# EUROPÄISCHE PATENTSCHRIFT

(11) **EP 1 155 348 B1**
(45) Veröffentlichungstag und Bekanntmachung des Hinweises auf die Patenterteilung: **04.06.2003**
(21) Anmeldenummer: 00901028.1
(22) Anmeldetag: 02.02.2000
(51) Int. Cl.: G02B 6/43, G02B 6/13

(54) **LEITERPLATTE FÜR ELECTRISCHE UND OPTISCHE SIGNALE SOWIE VERFAHREN ZU DEREN HERSTELLUNG**
PRINTED CIRCUIT BOARD FOR ELECTRICAL AND OPTICAL SIGNALS AND METHOD FOR PRODUCING THE SAME
PLAQUETTE A CIRCUITS IMPRIMES POUR SIGNAUX ELECTRIQUES ET OPTIQUES, ET PROCEDE DE FABRICATION DE LADITE PLAQUETTE

(30) Priorität: 23.02.1999 CH 33599
(43) Veröffentlichungstag der Anmeldung: 21.11.2001
(73) Patentinhaber: PPC Electronic AG, 6330 Cham (CH)
(72) Erfinder: STRAUB, Peter, Leo, CH-6317 Oberwil/Zug (CH)
(74) Vertreter: Isler & Pedrazzini AG
(86) Internationale Anmeldenummer: CH0000056
(87) Internationale Veröffentlichungsnummer: WO00050946

(56) Entgegenhaltungen:
- EP-A- 0 581 012
- WO-A-90/01176
- US-A- 5 249 245

## Beschreibung

### TECHNISCHES GEBIET

Die vorliegende Erfindung bezieht sich auf das Gebiet der Leiterplattentechnik. Sie betrifft eine Leiterplatte gemäß dem Oberbegriff des Anspruchs 1.

Eine solche Leiterplatte ist z.B. aus der Druckschrift WO-A1-90/01176 bekannt.

Die Erfindung betrifft weiterhin ein Verfahren zur Herstellung einer solchen Leiterplatte.

### STAND DER TECHNIK

Das Bedürfnis nach immer höheren Taktraten und schnelleren Signalübertragungen ist durch Kupferleitungen langfristig nicht mehr in ausreichender Qualität zu erfüllen. Durch optische Uebertragungswege (Lichtwellenleiter) ist es möglich, innerhalb von Montagerückwänden ("backplanes") und auch auf Systemboards Signale mit höchster Uebertragungsrate zu übertragen. Eine hohe Störsicherheit gegenüber elektromagnetischer Störstrahlung ist dabei ein sehr angenehmer Nebeneffekt, der besonders auf der elektrischen Backplane von besonderer Bedeutung ist. Eine solche Backplane ist beispielsweise verantwortlich für den Datenaustausch zwischen den einzelnen Prozessorkarten eines Multi-Prozessor-Hochleistungsrechners.

Es sind nun bereits verschiedentlich Vorschläge gemacht worden, um optische Datenübertragungswege in mehrlagige Leiterplatten zu integrieren. In der US-A-5,230,030 wird ein optisches Interface zur Ankopplung an eine elektronische Schaltung in Form von Multichip-Modulen beschrieben. Die einzelnen ICs sind auf einer mehrlagigen Leiterplatte montiert, die als Stapel aus alternierend angeordneten elektrisch leitenden und isolierenden Schichten besteht. In den isolierenden Schichten, die aus einem optisch durchsichtigen Material mit niedrigem Brechungsindex bestehen, werden Kanäle ausgehoben, die anschliessend mit einem anderen durchsichtigen Kunststoff mit höherem Brechungsindex aufgefüllt werden. Die Auffüllungen bilden dann optische Leiter, die einerseits in Verbindung mit den ICs stehen und andererseits an den Rand des Stapels geführt werden, um dort durch einen entsprechenden Stecker von aussen anschliessbar zu sein. Diese Art der Integration von optischen Leitern in eine Leiterplatte ist nicht nur aufwendig, weil die Leiterplatte sukzessive Schicht für Schicht aufgebaut und strukturiert werden muss. Die auf diese Weise erzeugte Qualität der optischen Leiter lässt auch zu wünschen übrig, weil beim Auffüllen der Kanäle mit dem optisch wirkenden Material eine gleichmässige und homogene Leiterstruktur nur schwer zu erreichen ist.

Ein anderer Vorschlag, der in der Druckschrift US-A-5,408,568 offenbart ist, integriert eine ganzflächige optische Schicht als Zwischenlage in eine mehrlagige Leiterplatte. Die optische Schicht wird an einer Seite durch eine stumpf aufgesetzte Lichtleitfaser nach aussen hin angekoppelt. Der Anschluss der auf der Oberseite der Leiterplatte plazierten Chips geschieht durch Bohrungen unterhalb der Chips, die bis zur optischen Schicht hinunterreichen. Die optische Schicht wirkt als einheitlicher optischer Datenbus, über den alle Chips untereinander oder mit der Aussenwelt Daten austauschen können. Ueber Dicke und Material dieser optischen Schicht werden in der Druckschrift keine Angaben gemacht. In der Fig. 1 der Schrift ist die optische Schicht mit derselben Dicke dargestellt wie die gedruckten Schaltungsplatten, zwischen denen sie angeordnet ist. Diese Art des Aufbaus dürfte daher für Leiterplatten mit mehreren optischen Ebenen und definierten optischen Verbindungen zwischen ausgewählten Chips nicht geeignet sein.

In der eingangs genannten WO-A1-90/01176 wird eine kombinierte elektrische und optische Schaltungsplatte beschrieben (z.B. Fig. 1), die einen Schichtaufbau aus einer optisch durchlässigen Schicht (2), einer optisch undurchlässigen Schicht (3) und einer elektrisch leitenden Schicht (4) aufweist. Die optisch durchlässige Schicht kann aus Kunststoff, Glas oder einem anderen optisch gut durchlässigen Material bestehen. Nähere Angaben zum Schichtmaterial und zur Dicke der Schicht werden nicht gemacht.

### DARSTELLUNG DER ERFINDUNG

Es ist daher Aufgabe der Erfindung, eine Leiterplatte für elektrische und optische Signale zu schaffen, die sich durch eine hohe Qualität der optischen Verbindungen, durch einen flexibel anpassbaren und leicht zu variierenden Aufbau sowie durch eine einfache Integration in bekannte Herstellungsverfahren für mehrlagige Leiterplatten auszeichnet.

Die Aufgabe wird bei einer Leiterplatte der eingangs genannten Art dadurch gelöst, dass die optische Leitungsebene als leitendes Element wenigstens eine Dünnglasschicht umfasst. Unter Dünnglasschicht wird dabei eine plattenartige Glasschicht geringer Dicke (ungefähr 1 mm Dicke und weniger) aber zugleich hoher optischer Qualität (Planität der Flächen) verstanden, wie sie z.B. für LCD-Displays, Solarzellen oder als Abdeckung für CCD-Schaltungen eingesetzt wird. Durch den Einsatz derartiger Dünnglasschichten ist es möglich, innerhalb der Leiterplatte eine oder mehrere platzsparende optische Leitungsebene(n) hoher Uebertragungsqualität vorzusehen, die zudem bei Bedarf auf einfache Weise strukturiert werden können, um eine lokalisierte optische Verbindung innerhalb der Leiterplatte zu realisieren.

Eine erste bevorzugte Ausführungsform der Leiterplatte nach der Erfindung zeichnet sich dadurch aus, dass die optische Leitungsebene jeweils durch ein optisches Sandwich gebildet wird, welches neben der wenigstens einen Dünnglasschicht wenigstens eine Trägerplatte umfasst, die mit der wenigstens einen Dünnglasschicht flächig verbunden ist. Durch die Kombination der Dünnglasschicht mit einer Trägerplatte ist es möglich, das entstehende optische Sandwich separat von der Herstellung der eigentlichen Leiterplatte vorzufertigen und flexibel den jeweiligen Bedürfnissen der Schaltung anzupassen (z.B. zu strukturieren). Das vorgefertigte optische Sandwich kann dann ohne wesentliche Aenderungen der Prozessführung als zusätzliche Leitungsebene bzw. -lage in einen herkömmlichen Herstellungsprozess für eine mehrlagige Leiterplatte eingeführt werden.

Es ist dabei möglich, dass das optische Sandwich wenigstens zwei Trägerplatten umfasst, zwischen denen die wenigstens eine Dünnglasschicht angeordnet ist. Die Dünnglasschicht ist dann für die weitere Verarbeitung vollständig geschützt. Es ist aber auch ebensogut möglich, dass das optische Sandwich wenigstens zwei Dünnglasschichten umfasst, welche mit der wenigstens einen Trägerplatte flächige verbunden sind, wobei entweder die wenigstens zwei Dünnglasschichten auf einer Seite der wenigstens einen Trägerplatte angeordnet und miteinander flächig verbunden sind, oder die wenigstens zwei Dünnglasschichten auf gegenüberliegenden Seiten der wenigstens einen Trägerplatte angeordnet sind. Auf diese Weise lassen sich pro optischem Sandwich zwei unterschiedliche, separat auslegbare optische Leitungsebenen in die Leiterplatte integrieren. Selbstverständlich kann die Anzahl der Trägerplatten und Dünnglasschichten pro optischem Sandwich im Rahmen der Erfindung auch weiter erhöht werden, wodurch sich die Herstellung allerdings verkompliziert.

Ein zweite bevorzugte Ausführungsform der erfindungsgemässen Leiterplatte ist dadurch gekennzeichnet, dass die Trägerplatten aus einem elektrisch isolierenden Material, welches als Basismaterial für die Herstellung elektrischer Leiterplatten Verwendung findet, vorzugsweise aus einem aramidverstärkten Harz, bestehen. Dadurch wird gewährleistet, dass sich die optischen Sandwiches besonders gut in den herkömmlichen Herstellungsprozess für mehrlagige Leiterplatten einfügen lassen.

Die Dünnglasschichten weisen erfindungsgemäß eine Dicke kleiner gleich 1,1 mm auf und bestehen aus einem Borosilikatglas. Ein solches Dünnglas, das beispielsweise unter den Typenbezeichnungen AF 45 und D 263 von der deutschen Firma DESAG für Anwendungen in LCD-Displays oder Solarzellen angeboten wird, und in Dicken zwischen 30 µm und 1,1 mm erhältlich ist, ist als optische Leitungsschicht wegen der hohen optischen Qualität besonders geeignet.

Grundsätzlich kann die Dünnglasschicht unstrukturiert sein und bildet dann einen einzigen, einfach zusammenhängenden, durchgehenden optischen Leiter. Eine weitere bevorzugte Ausführungsform der Leiterplatte nach der Erfindung zeichnet sich jedoch dadurch aus, dass zumindest einzelne der Dünnglasschichten derart strukturiert sind, dass innerhalb der Schicht einzelne, durch Zwischenräume voneinander getrennte optische Leiter entstehen. Auf diese Weise können in einer Ebene ein Vielzahl von untereinander unabhängigen optischen Leitern erzeugt werden, die ohne gegenseitige Störung verschieden Uebertragungsaufgaben übernehmen können.

Die optischen Eigenschaften der einzelnen optischen Leiter können dann dadurch optimiert werden, dass entweder die freiliegenden Oberflächen der einzelnen optischen Leiter mit einer Reflexionsschicht bedeckt sind, oder die Zwischenräume zwischen den optischen Leitern mit einem Füllmaterial aufgefüllt sind, das insbesondere einen Brechungsindex hat, der kleiner ist als der Brechungsindex des Glases der Dünnglasschicht.

Eine weitere bevorzugte Ausführungsform der erfindungsgemässen Leiterplatte ist dadurch gekennzeichnet, dass zur optischen Ankopplung von auf der Oberund/oder Unterseite der Leiterplatte angeordneten optisch aktiven Elementen Koppelöffnungen vorgesehen sind, durch welche die in einer optischen Leitungsebene liegende(n) verdeckte(n) Dünnglasschicht bzw. optischen Leiter von aussen zugänglich sind.

Das erfindungsgemässe Verfahren zur Herstellung einer Leiterplatte ist durch die Merkmale des Anspruchs 14 gekennzeichnet.

Weitere Ausführungsformen ergeben sich aus den abhängigen Ansprüchen.

### KURZE ERLÄUTERUNG DER FIGUREN

Die Erfindung soll nachfolgend anhand von Ausführungsbeispielen im Zusammenhang mit der Zeichnung näher erläutert werden. Es zeigen
- Fig. 1A-D: in perspektivischer, teilweise geschnittener Darstellung verschieden Stufen bei der Herstellung eines "optischen Sandwich" mit strukturierter Dünnglasschicht gemäss einem bevorzugten Ausführungsbeispiel der Erfindung;
- Fig. 2: ein zu Fig. 1D alternatives Ausführungsbeispiel mit einer Dünnglasschicht zwischen zwei Trägerplatten;
- Fig. 3: ein zu Fig. 1 D alternatives Ausführungsbeispiel mit zwei übereinander angeordneten Dünnglasschichten auf einer Seite der Trägerplatte;
- Fig. 4: ein zu Fig. 1 D alternatives Ausführungsbeispiel mit zwei Dünnglasschichten auf den gegenüberliegenden Seiten der Trägerplatte;
- Fig. 5: in einer vergrösserten Schnittdarstellung das optische Sandwich nach Fig. 1 D mit den durch ein optisch angepasstes Füllmaterial ausgefüllten Zwischenräumen der strukturierten Dünnglasschicht;
- Fig. 6: ein zu Fig. 5 alternatives Ausführungsbeispiel mit einer Abdeckung der strukturierten Dünnglasschicht durch eine Reflexionsschicht; und
- Fig. 7: ein Ausführungsbeispiel einer Leiterplatte nach der Erfindung mit drei optischen Leitungsebenen (Sandwiches) gemäss Fig. 2, die durch zwei dazwischenliegende elektrische Leitungsebenen voneinander getrennt sind.

### WEGE ZUR AUSFÜHRUNG DER ERFINDUNG

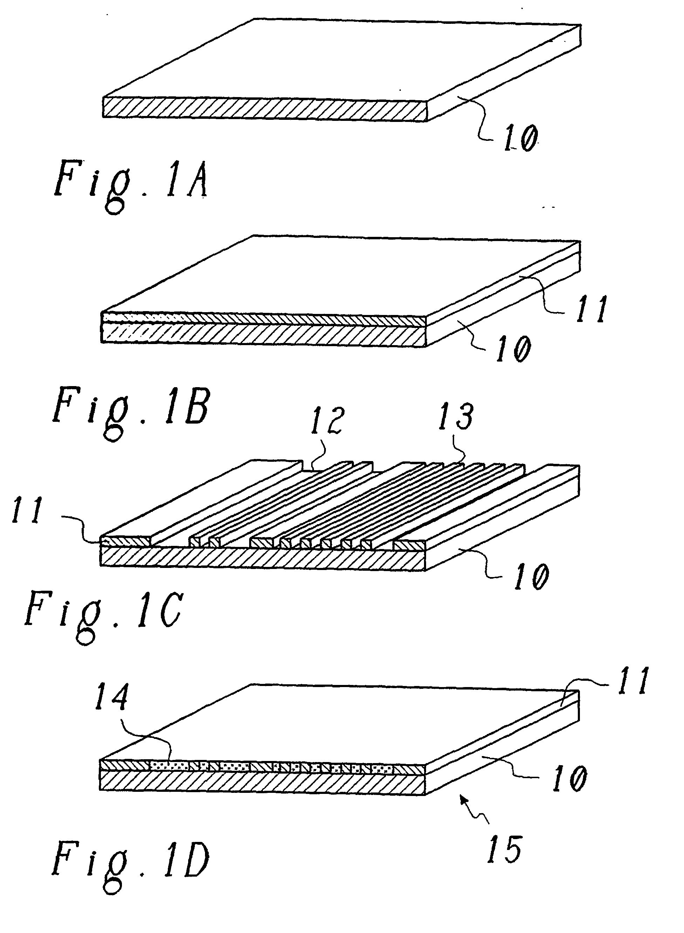

Bei der Herstellung einer Leiterplatte nach der Erfindung werden zunächst einzelne sogenannte "optische Sandwiches" hergestellt, welche in der späteren Leiterplatte die optische Leitungsebene bilden. Die Herstellung der optischen Sandwiches läuft in mehreren Schritten ab, die beispielhaft in den Fig. 1A bis 1D wiedergegeben sind. Ausgegangen wird von einer Trägerplatte 10 (Fig. 1A), die auf der Ober- und Unterseite plane Flächen aufweist und aus einem elektrisch isolierenden Material besteht, wie es bei der Herstellung elektrischer Leiterplatten verwendet wird. Damit ist sichergestellt, dass das fertige optische Sandwich von seinen Materialeigenschaften her gut in vorhanden Leiterplattenprozesse integrierbar ist. Verwendet wird als Material vorzugsweise ein aramidverstärktes Harz. Derartige Trägerplatten sind z.B. unter der Typbezeichnung Duramid-P-Cu 115 ML von der deutschen Firma Isola erhältlich. Es ist aber auch jedes andere Isolationsmaterial mit isotropen Eigenschaften und glasähnlichen Ausdehnungskoeffizienten verwendbar. Die Dicke der Trägerplatte 10 ist dabei so gewählt, dass die Trägerplatte 10 dem optischen Sandwich einerseits eine ausreichende mechanische Stabilität verleiht, dass sie aber andererseits bei der späteren Integration in die Leiterplatte nicht unnötig viel Höhe beansprucht.

Die Trägerplatte 10 wird nun gemäss Fig. 1 B flächig mit einer Dünnglasschicht 11 mittels Verpressen bzw. Verkleben verbunden. Die Dünnglasschicht 11 besteht vorzugsweise aus einem Borosilikatglas und hat eine Dicke von kleiner gleich 1,1 mm (30 µm bis 1,1 mm). Dünngläser dieser Art sind beispielsweise unter der Typenbezeichnung AF 45 und D 263 von der deutschen Firma DESAG erhältlich. Das Dünnglas AF 45 ist ein modifiziertes Borosilikatglas mit einem hohen Gehalt an BaO und Al₂O₃ und zeichnet sich unter anderem durch einen niedrigen thermischen Ausdehnungskoeffizienten und eine hohe Lichtdurchlässigkeit aus. Durch die engen Toleranzen und die feuerpolierten Oberflächen ist es besonders geeignet für flächige optische Anwendungen wie z.B. LCD-Displays, Abdeckungen von CCD-Elementen, Solarzellen oder dgl.. Das Dünnglas D 263 ist ein Borosilikatglass mit entsprechenden optischen Eigenschaften. Beide Dünngläser sind mit einer Dicke im Bereich zwischen 30 µm bis 1,1 mm erhältlich.

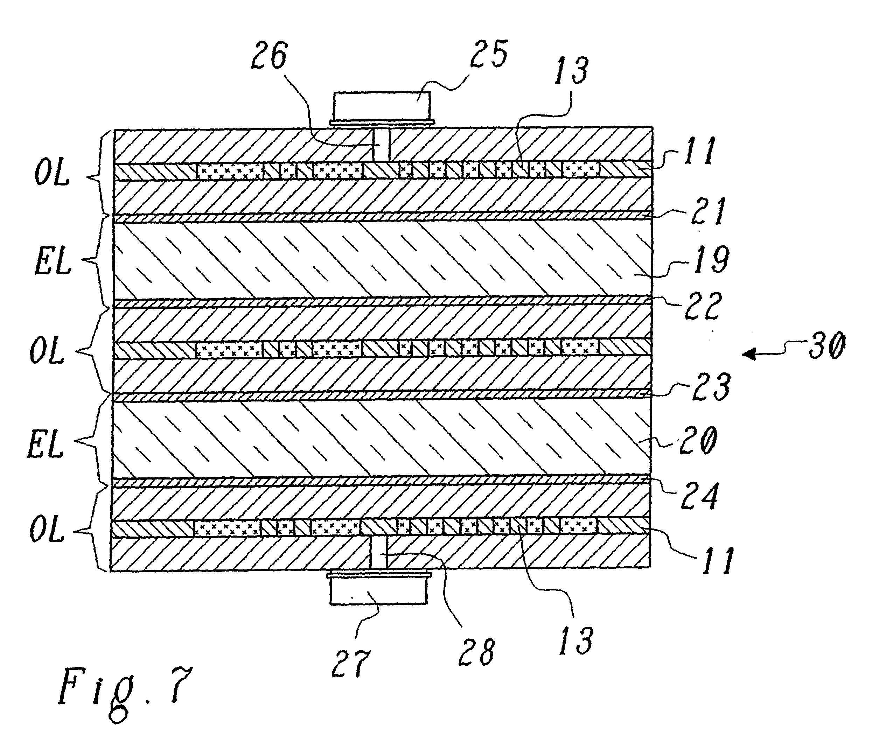

Wenn in der späteren Leiterplatte die optische Leitungsebene nur als gemeinsamer Datenbus vorgesehen ist, kann ein optisches Sandwich gemäss Fig. 1B mit unstrukturierter Dünnglasschicht direkt in die Leiterplatte integriert werden (siehe Fig. 7). Werden dagegen in der Leiterplatte einzelne optische Leitungsverbindungen zwischen verschiedenen Punkten der Platte benötigt, wird die Dünnglasschicht nach dem Aufbau des optischen Sandwiches gemäss Fig. 1C strukturiert, indem die Dünnglasschicht in bestimmten Bereichen vollständig abgetragen wird, um Zwischenräume 12 zwischen einzelnen optischen Leitern 13 zu bilden. Die einzelnen optischen Leiter 13 können dabei (wie in Fig. 1C dargestellt) unterschiedliche Breiten aufweisen. Sie können untereinander parallel verlaufen und gleich oder unterschiedliche Längen aufweisen; sie können aber auch gebogen oder anderweitig geformt sein, soweit es mit ihrer Funktion als optische Leiter vereinbar ist. Das Ausheben der Zwischenräume 12 kann durch unterschiedliche Techniken erfolgen. Denkbar ist ein mechanisches Ausheben mittels Schleifen oder Fräsen. Denkbar ist aber auch ein Abtragen mittels Laser oder durch chemische Verfahren.

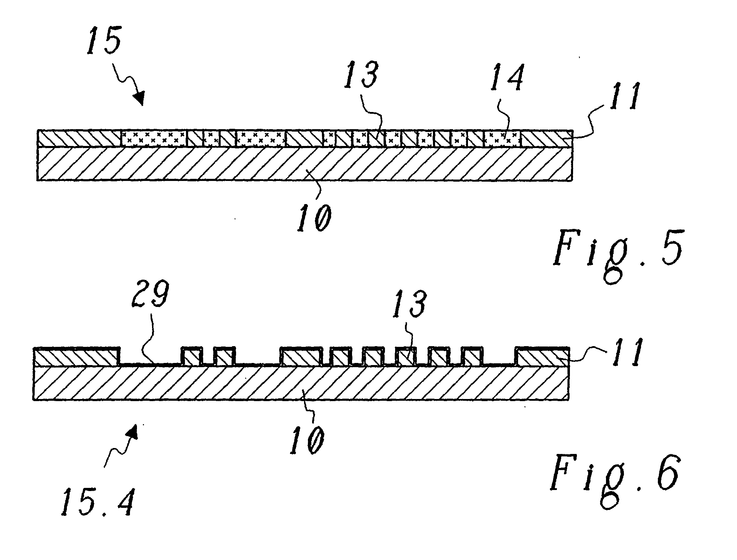

Nachdem die Dünnglasschicht 11 strukturiert ist, werden zur Fertigstellung des optischen Sandwiches 15 die entstandenen Zwischenräume 13 mit einem Füllmaterial 14 aufgefüllt (Fig. 1D bzw. Fig. 5). Das Auffüllen hat einerseits den Vorteil, dass auf der Oberseite der Dünnglasschicht 11 eine mechanisch stabile ebene Oberfläche entsteht. Andererseits sorgt das Füllmaterial 14 - wenn es einen Brechungsindex aufweist, der kleiner ist als der Brechungsindex des Glases der Dünnglasschicht 11 - für eine Totalreflexion in den optischen Leitern 13 und damit für gute optische Leitungseigenschaften. Dieselben guten optischen Eigenschaften lassen sich aber auch erreichen, wenn - wie in Fig. 6 gezeigt - beim optischen Sandwich 15.4 die freien Oberflächen der strukturierten Dünnglasschicht 11 bzw. der optischen Leiter 13 mit einer vorzugsweise metallischen Reflexionsschicht 29 durch Aufdampfen, oder galvanische oder chemische Abscheidung beschichtet werden. Auch in diesem Fall können die verbleibenden Zwischenräume aus mechanischen Gründen nachträglich wieder mit einem Füllmaterial aufgefüllt werden.

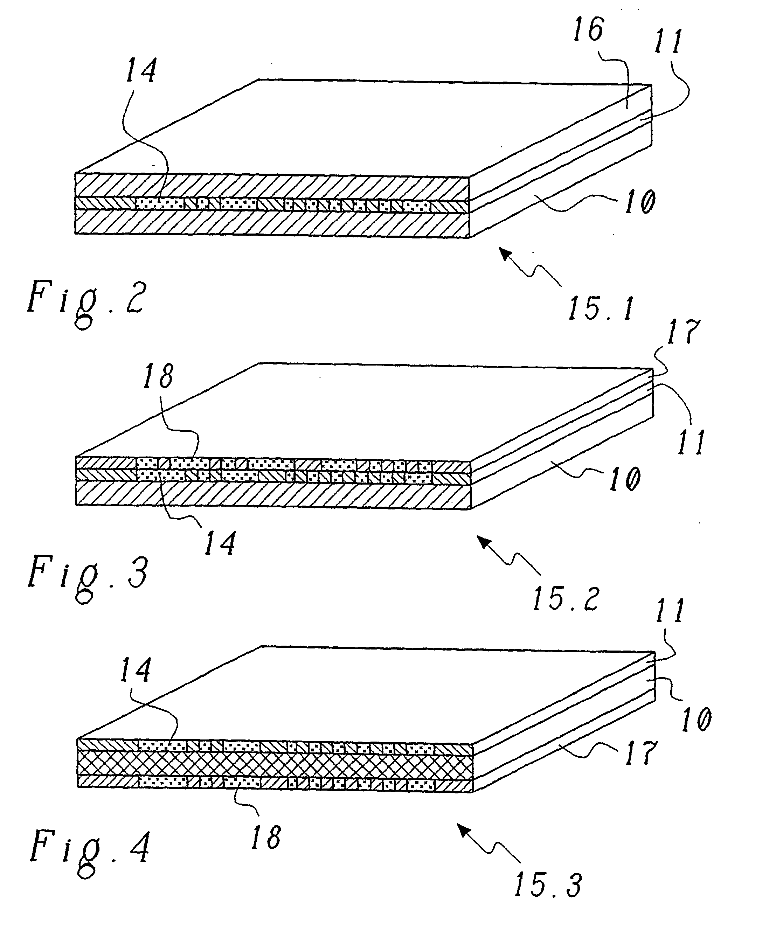

Anstelle des aus zwei Schichten 10 und 11 bestehenden optischen Sandwiches 15 aus Fig. 1D können auch optische Sandwiches verwendet werden, die mehr als zwei Schichten umfassen. Beim optischen Sandwich 15.1 aus Fig. 2 ist die Dünnglasschicht 11 beidseitig mit Trägerplatten 10 und 16 verbunden. Hierdurch wird die mechanische Stabilität weiter erhöht. Gleichzeitig weist das optische Sandwich 15.1 auf Ober- und Unterseite als Verbindungsfläche das Leiterplattenmaterial der Trägerplatten 10 und 16 auf und ist daher besonders gut in den Fertigungsprozess der Leiterplatte zu integrieren.

Beim optischen Sandwich 15.2 der Fig. 3 wird über der ersten strukturierten Dünnglasschicht 11 ein zweite strukturierte Dünnglasschicht 17 angeordnet, die eine zweite optische Leitungsebene bildet und so mit wenig Platzaufwand für zusätzliche optische Verbindungen innerhalb der Leiterplatte sorgt. Auch bei der zweiten Dünnglasschicht 17 sind die Zwischenräume zweckmässigerweise durch ein Füllmaterial 18 aufgefüllt.

Beim optischen Sandwich 15.3 der Fig. 4 schliesslich ist auf den gegenüberliegenden Seiten der Trägerplatte 10 jeweils eine strukturierte Dünnglasschicht 11 und 17 mit durch Füllmaterial 14 bzw. 18 aufgefüllten Zwischenräumen vorgesehen, wodurch ein klare Trennung der Dünnglasschichten 11 und 17erreicht wird. Es versteht sich von selbst, dass im Rahmen der Erfindung auch andere Kombinationen aus Dünnglasschichten und Trägerplatten denkbar sind.

Die fertigen optischen Sandwiches 15 bzw. 15.1 bis 15.4 können nun zusammen mit herkömmlichen, beidseitig metallisierten elektrischen Leiterplatten, in einem Stapel kombiniert und zu einer fertigen Leiterplatte für optische und elektrische Signale verbunden werden. Die mechanische Stabilität der Sandwiches ermöglicht dabei eine problemlose Integration in der Fertigungsprozess. Eine solche beispielhafte Leiterplatte 30 mit drei optischen und zwei elektrischen Leitungsebenen ist in Fig. 7 im Schnitt wiedergegeben. Die (drei) optischen Leitungsebenen OL der Leiterplatte 30 werden durch drei optische Sandwiches 15.1 gemäss Fig. 2 gebildet. Zwischen den Optischen Leitungsebenen OL sind alternierend zwei elektrische Leitungsebenen EL angeordnet, die jeweils in herkömmlicher Weise aus einer dielektrischen Schicht 19 bzw. 20 bestehen, die beidseitig mit einer Metallschicht 21, 22 bzw. 23, 24 (z.B. Cu-Kaschierung) belegt ist. Alle Schichten sind miteinander verpresst bzw. verklebt. Sowohl die Dünnglasschichten der optischen Leitungsebenen OL als auch die Metallschichten der elektrischen Leitungsebenen EL sind nach den Erfordernissen der auf mittels der Leiterplatte 30 aufgebauten Schaltung strukturiert, wobei die Strukturierung der elektrischen Leitungsebenen EL auf an sich bekannte Weise (z.B. durch Aetzen der Metallschichten 21-24) geschieht; eine Strukturierung der Metallschichten 21-24 ist in Fig. 7 der Einfachheit halber nicht dargestellt . Selbstverständlich können zwischen den elektrischen Leitungsebenen EL Durchkontaktierungen vorgesehen werden, wie dies aus der Technik der mehrlagigen Leiterplatten bekannt und üblich ist.

Sollen durch die optischen Leitungsebenen OL optisch aktive Elemente bzw. Chips 25, 27 untereinander oder mit optischen Eingängen oder Ausgängen, Steckverbindungen oder dgl. verbunden werden, werden zur optischen Ankopplung der auf der Ober- und/oder Unterseite der Leiterplatte 30 angeordneten Elementen 25, 27 Koppelöffnungen 26, 28 in die Leiterplatte 30 eingebracht, durch welche die in einer optischen Leitungsebene OL liegenden verdeckten Dünnglasschichten 11 bzw. optischen Leiter 13 von aussen zugänglich sind. Entsprechend lassen sich rein elektronische Chips, die auf der Leiterplatte angeordnet sind, mittels (in Fig. 7 nicht gezeigter) Durchkontaktierungen mit den elektrischen Leitungsebenen EL verbinden.

### BEZUGSZEICHENLISTE

- 10,16: Trägerplatte
- 11,17: Dünnglasschicht
- 12: Zwischenraum
- 13: optischer Leiter
- 14,18: Füllmaterial
- 15; 15.1-15.3: optisches Sandwich
- 19,20: dielektrische Schicht
- 21-24: Metallschicht (z.B. Cu)
- 25,27: optisch aktives Element (optischer Chip)
- 26,28: Koppelöffnung
- 29: Reflexionsschicht
- 30: Leiterplatte
- EL: elektrische Leitungsebene
- OL: optische Leitungsebene

## Patentansprüche

1. Leiterplatte (30) mit wenigstens einer elektrischen Leitungsebene (EL) zur Weiterleitung von elektrischen Signalen und/oder Strömen sowie wenigstens einer optischen Leitungsebene (OL) zur Weiterleitung von optischen Signalen, welche Leitungsebenen (EL, OL) innerhalb der Leiterplatte in einem Stapel übereinander angeordnet und miteinander verbunden sind, wobei die optische Leitungsebene (OL) als leitendes Element wenigstens eine Glasschicht (11, 17) umfasst, **dadurch gekennzeichnet, dass** die wenigstens eine Glasschicht eine Dünnglasschicht (11, 17) mit einer Dicke kleiner gleich 1,1 mm ist und aus einem Borositikatglas besteht.

2. Leiterplatte nach Anspruch 1, **dadurch gekennzeichnet, dass** die optische Leitungseberie (OL) jeweils durch ein optisches Sandwich (15; 15.1, .., 15.3) gebildet wird, welches neben der wenigstens einen Dünnglasschicht (11, 17) wenigstens eine Trägerplatte (10, 16) umfasst, die mit der wenigstens einen Dünnglasschicht (11, 17) flächig verbunden ist.

3. Leiterplatte nach Anspruch 2, **dadurch gekennzeichnet, dass** das optische Sandwich (15.1) wenigstens zwei Trägerplatten (10, 16) umfasst, zwischen denen die wenigstens eine Dünnglasschicht (11) angeordnet ist.

4. Leiterplatte nach Anspruch 2, **dadurch gekennzeichnet, dass** das optische Sandwich (15.2, 15.3) wenigstens zwei Dünnglasschichten (11, 17) umfasst, welche mit der wenigstens einen Trägerplatte (10) flächige verbunden sind.

5. Leiterplatte nach Anspruch 4, **dadurch gekennzeichnet, dass** die wenigstens zwei Dünnglasschichten (11, 17) auf einer Seite der wenigstens einen Trägerplatte (10) angeordnet und miteinander flächig verbunden sind.

6. Leiterplatte nach Anspruch 4, **dadurch gekennzeichnet, dass** die wenigstens zwei Dünnglasschichten (11, 17) auf gegenüberliegenden Seiten der wenigstens einen Trägerplatte (10) angeordnet sind.

7. Leiterplatte nach einem der Ansprüche 2 bis 6, **dadurch gekennzeichnet, dass** die Trägerplatten (10, 16) aus einem elektrisch isolierenden Material, welches als Basismaterial für die Herstellung elektrischer Leiterplatten Verwendung findet, vorzugsweise aus einem aramidverstärkten Harz, bestehen.

8. Leiterplatte nach einem der Ansprüche 1 bis 7, **dadurch gekennzeichnet, dass** die Dünnglasschichten (11, 17) und die Trägerplatten (10, 16) miteinander verklebt bzw. verpresst sind.

9. Leiterplatte nach einem der Ansprüche 1 bis 8, **dadurch gekennzeichnet, dass** zumindest einzelne der Dünnglasschichten (11, 17) als durchgehende Schichten ausgebildet ist.

10. Leiterplatte nach einem der Ansprüche 1 bis 8, **dadurch gekennzeichnet, dass** zumindest einzelne der Dünnglasschichten (11, 17) derart strukturiert sind, dass innerhalb der Schicht einzelne, durch Zwischenräume (12) voneinander getrennte optische Leiter (13) entstehen.

11. Leiterplatte nach Anspruch 10, **dadurch gekennzeichnet, dass** die freiliegenden Oberflächen der einzelnen optischen Leiter (13) mit einer Reflexionsschicht (29) bedeckt sind.

12. Leiterplatte nach einem der Ansprüche 10 und 11, **dadurch gekennzeichnet, dass** die Zwischenräume (12) zwischen den optischen Leitern (13) mit einem Füllmaterial (14, 18) aufgefüllt sind.

13. Leiterplatte nach einem der Ansprüche 1 bis 12, **dadurch gekennzeichnet, dass** zur optischen Ankopplung von auf der Ober- und/oder Unterseite der Leiterplatte (30) angeordneten optisch aktiven Elementen (25, 27) Koppelöffnungen (26, 28) vorgesehen sind, durch weiche die in einer optischen Leitungsebene (OL) liegende(n) verdeckte(n) Dünnglasschicht (11, 17) bzw. optischen Leiter (13) von aussen zugänglich sind.

14. Verfahren zur Herstellung einer Leiterplatte nach einem der Ansprüche 1 bis 13, **dadurch gekennzeichnet, dass** in einem ersten Schritt wenigstens eine Dünnglasschicht (11, 17) aus einem Borosilikatglas und mit einer Dicke kleiner gleich 1,1 mm mit wenigstens einer Trägerplatte (10, 16) ganzflächig zu einem optischen Sandwich (15; 15.1, .., 15.3) verbunden wird, und dass in einem zweiten Schritt das optische Sandwich (15; 15.1, .., 15.3) als optische Leitungsebene (OL) mit einer oder mehreren elektrischen Leitungsebene(n) (EL) in einer Stapelanordnung zu der Leiterplatte (30) verbunden wird.

15. Verfahren nach Anspruch 14, **dadurch gekennzeichnet, dass** die Dünnglasschicht (11, 17) und die Trägerplatte (10, 16) durch Verpressen bzw. Verkleben miteinander verbunden werden.

16. Verfahren nach einem der Ansprüche 14 und 15, **dadurch gekennzeichnet, dass** zwischen dem ersten und dem zweiten Schritt die mit der Trägerplatte (10, 16) verbundene Dünnglasschicht (11, 17) strukturiert wird.

17. Verfahren nach Anspruch 16, dass zum Strukturieren der Dünnglasschicht (11, 17) in vorbestimmten Bereichen die Dünnglasschicht abgetragen wird, so dass durch Zwischenräume (12) voneinander getrennte, einzelne optische Leiter (13) entstehen.

18. Verfahren nach Anspruch 17, **dadurch gekennzeichnet, dass** die Abtragung der Dünnglasschicht (11, 17) mittels Laser, mechanisch oder auf chemischem Wege erfolgt.

19. Verfahren nach einem der Ansprüche 16 bis 18, **dadurch gekennzeichnet, dass** die freie Oberfläche der strukturierten Dünnglasschicht (11) mit einer Reflexionsschicht (29), vorzugsweise aus einem Metall, durch Aufdampfen, galvanische oder chemische Abscheidung beschichtet wird.

20. Verfahren nach einem der Ansprüche 16 bis 19, **dadurch gekennzeichnet, dass** die Zwischenräume (12) der strukturierten Dünnglasschicht (11, 17) mit einem Füllmaterial (14, 18) aufgefüllt werden, welches einen Brechungsindex aufweist, der kleiner ist als der Brechungsindex des Glases der Dünnglasschicht (11, 17).

## Claims

1. A circuit board (30) with at least one electrically conductive plane (EL) for transmitting electric signals and/or currents, and with an optically conductive plane (OL) for transmitting optical signals, wherein said conductive planes (EL, OL) are arranged on top of one another in the form of a stack within the circuit board and connected to one another, and wherein the optically conductive plane (OL) comprises at least one glass layer (11, 17) as the conductive element, **characterized by** the fact that the at least one glass layer consists of a thin glass layer (11, 17) that has a thickness of less than or equal to 1.1 mm and is made of a borosilicate glass.

2. The circuit board according to Claim 1, **characterized by** the fact that the optically conductive plane (OL) is respectively formed by an optical sandwich (15; 15.1, ..., 15.3) that, in addition to the at least one thin glass layer (11, 17), comprises at least one carrier plate (10, 16) that is connected to the surface of the at least one thin glass layer (11, 17).

3. The circuit board according to Claim 2, **characterized by** the fact that the optical sandwich (15.1) comprises at least two carrier plates (10, 16), between which the at least one thin glass layer (11) is arranged.

4. The circuit board according to Claim 2, **characterized by** the fact that the optical sandwich (15.2, 15.3) comprises at least two thin glass layers (11, 17), the surfaces of which are connected to the at least one carrier plate (10).

5. The circuit board according to Claim 4, **characterized by** the fact that the at least two thin glass layers (11, 17) are arranged on one side of the at least one carrier plate (10), wherein the surfaces of the at least two thin glass layers are connected to one another.

6. The circuit board according to Claim 4, **characterized by** the fact that the at least two thin glass layers (11, 17) are arranged on opposite sides of the at least one carrier plate (10).

7. The circuit board according to one of Claims 2-6, **characterized by** the fact that the carrier plates (10, 16) consist of an electrically insulating material that is used as the base material in the manufacture of electric circuit boards, preferably an aramide-reinforced resin.

8. The circuit board according to one of Claims 1-7, **characterized by** the fact that the thin glass layers (11, 17) and the carrier plates (10, 16) are bonded and pressed to one another.

9. The circuit board according to one of Claims 1-8, **characterized by** the fact that at least individual thin glass layers (11, 17) are realized in the form of continuous layers.

10. The circuit board according to one of Claims 1-8, **characterized by** the fact that at least individual thin glass layers (11, 17) are structured in such a way that individual optical conductors (13) are formed within the layer which are separated from one another by intermediate spaces (12).

11. The circuit board according to Claim 10, **characterized by** the fact that the exposed surfaces of the individual optical conductors (13) are covered with a reflective layer (29).

12. The circuit board according to Claim 10 or 11, **characterized by** the fact that the intermediate spaces (12) between the optical conductors (13) are filled with a filler material (14, 18).

13. The circuit board according to one of Claims 1-12, **characterized by** the fact that coupling openings (26, 28) are provided for realizing the optical coupling of optically active elements (25, 27) arranged on the upper and/or the lower side of the circuit board (30), wherein the concealed thin glass layer(s) (11, 17) that lie(s) in an optically conductive plane (OL) and the optical conductor(s) (13) are accessible from the outside through said coupling openings.

14. A method for manufacturing a circuit board according to one of Claims 1-13, **characterized by** the fact that at least one thin glass layer (11, 17) of a borosilicate glass which has a thickness of less than or equal to 1.1 mm is connected over its entire surface to at least one carrier plate (10, 16) in a first step such that an optical sandwich (15; 15.1, ..., 15.3) is formed, and by the fact the optical sandwich (15; 15.1, ..., 15.3) that forms an optically conductive plane (OL) is connected to one or more electrically conductive plane(s) (EL) in a second step, namely in the form of a stack arrangement such that a circuit board (30) is formed.

15. The method according to Claim 14, **characterized by** the fact that the thin glass layer (11, 17) and the carrier plate (10, 16) are connected to one another by pressing or bonding.

16. The method according to Claim 14 or 15, **characterized by** the fact that the thin glass layer (11, 17) connected to the carrier plate (10, 16) is structured between the first step and the second step.

17. The method according to Claim 16, **characterized by** the fact that the thin glass layer is removed in predetermined regions in order to structure the thin glass layer (11, 17), namely such that individual optical conductors (13) are formed which are separated from one another by intermediate spaces (12).

18. The method according to Claim 17, **characterized by** the fact that the thin glass layer (11, 17) is removed by means of a laser, mechanically or chemically.

19. The method according to one of Claims 16-18, **characterized by** the fact that the exposed surface of the structured thin glass layer (11) is coated with a reflective layer (29) that preferably consists of a metal, namely by means of vapor deposition or galvanic or chemical deposition.

20. The method according to one of Claims 16-19, **characterized by** the fact that the intermediate spaces (12) of the structured thin glass layer (11, 17) are filled with a filler material (14, 18) that has a lower refractive index than that of the glass of the thin glass layer (11, 17).

## Revendications

1. Circuit imprimé (30) avec au moins un plan conducteur électrique (EL) pour la transmission de signaux et/ou flux électriques et au moins un plan conducteur optique (OL) pour la transmission de signaux optiques, lesquels plans conducteurs (EL, OL) étant empilés et reliés les uns aux autres à l'intérieur du circuit imprimé, le plan conducteur optique (OL) comportant comme élément conducteur au moins une couche de verre (11, 17), **caractérisé en ce que** la couche de verre, au moins une, est une couche de verre mince (11, 17) d'une épaisseur inférieure ou égale à 1,1 mm et est composée de verre borosilicaté.

2. Circuit imprimé selon la revendication 1, **caractérisé en ce que** le plan conducteur optique (OL) est constitué respectivement par un sandwich optique (15 ; 15.1, ..., 15.3) qui comporte, outre au moins une couche de verre mince (11, 17), au moins une plaque support (10, 16), qui est reliée en surface à au moins une couche de verre mince (11, 17).

3. Circuit imprimé selon la revendication 2, **caractérisé en ce que** le sandwich optique (15.1) comporte au moins deux plaques supports (10, 16), entre lesquelles au moins une couche de verre mince (11) est placée.

4. Circuit imprimé selon la revendication 2, **caractérisé en ce que** le sandwich optique (15.2, 15.3) comporte au moins deux couches de verre mince (11, 17), qui sont reliées en surface à la plaque support (10), au moins une.

5. Circuit imprimé selon la revendication 4, **caractérisé en ce que** les couches de verre mince (11, 17), au moins deux, sont placées sur une face d'au moins une plaque support (10) et sont assemblées en surface.

6. Circuit imprimé selon la revendication 4, **caractérisé en ce que** les couches de verre mince (11, 17), au moins deux sont placées sur les faces opposées d'au moins une des plaques supports (10).

7. Circuit imprimé selon une des revendications 2 à 6, **caractérisé en ce que** les plaques supports (10, 16) consistent en une matière isolante du point de vue électrique, qui est utilisée comme matière de base pour la fabrication de circuits imprimés électriques, de préférence une résine renforcée à l'aramide.

8. Circuit imprimé selon une des revendications 1 à 7, **caractérisé en ce que** les couches de verre mince (11, 17) et les plaques supports (10, 16) sont collées ou pressées ensemble.

9. Circuit imprimé selon une des revendications 1 à 8, **caractérisé en ce qu'**au moins quelques unes des couches de verre mince (11, 17) sont constituées de couches continues.

10. Circuit imprimé selon une des revendications 1 à 8, **caractérisé en ce qu'**au moins quelques unes des couches de verre mince (11, 17) sont structurées de telle manière qu'au sein de la couche se forment quelques conducteurs optiques (13) séparés les uns des autres par des intervalles (12).

11. Circuit imprimé selon la revendication 10, **caractérisé en ce que** les surfaces dégagées des différents conducteurs optiques (13) sont recouvertes d'une couche réfléchissante (29).

12. Circuit imprimé selon une des revendications 10 et 11, **caractérisé en ce que** les intervalles (12) entre les conducteurs optiques (13) sont comblés par une matière de remplissage (14, 18).

13. Circuit imprimé selon une des revendications 1 à 12, **caractérisé en ce que**, pour le couplage optique d'éléments (25, 27) actifs au point de vue optique placés sur la face supérieure ou inférieure du circuit imprimé (30), des ouvertures de couplage (26, 28) sont prévues, par lesquelles la(les) couche(s) de verre mince(s) recouverte(s) située(s) (11, 17) dans un plan conducteur optique (OL) ou les conducteurs optiques (13) sont accessibles de l'extérieur.

14. Procédé de fabrication d'un circuit imprimé selon une des revendications 1 à 13, **caractérisé en ce que**, dans une première étape, au moins une couche de verre mince (11, 17) en verre borosilicaté et d'une épaisseur inférieure ou égale à 1,1 mm est reliée sur toute sa surface à au moins une plaque support (10, 16) pour former un sandwich optique (15 ; 15.1, ... 15.3) et que, dans une deuxième étape, le sandwich optique (15 ; 15.1, ..., 15.3) est relié en tant que plan conducteur optique (OL), par un ou plusieurs plans conducteurs électriques (EL) formant une pile, au circuit imprimé (30).

15. Procédé selon la revendication 14, **caractérisé en ce que** la couche de verre mince (11, 17) et la plaque support (10, 16) sont assemblées par pressage ou collage.

16. Procédé selon une des revendications 14 et 15, **caractérisé en ce qu'**entre la première et la deuxième étape, la couche de verre mince (11, 17) reliée à la plaque support (10, 16) est structurée.

17. Procédé selon la revendication 16, **caractérisé en ce que**, pour structurer la couche de verre mince (11, 17), la couche de verre mince est évidée à des endroits donnés, formant ainsi différents conducteurs optiques (13) séparés les uns des autres par des intervalles (12).

18. Procédé selon la revendication 17, **caractérisé en ce que** l'évidement de la couche de verre mince (11, 17) est réalisé au laser, par méthode mécanique ou chimique.

19. Procédé selon une des revendications 16 à 18, **caractérisé en ce que** la surface dégagée de la couche structurée de verre mince (11) est recouverte d'une couche réfléchissante (29), de préférence en métal, par vaporisation, galvanisation ou séparation chimique.

20. Procédé selon une des revendications 16 à 19, **caractérisé en ce que** les intervalles (12) de la couche structurée de verre mince (11, 17) sont comblés par une matière de remplissage (14, 18) qui présente un indice de réfraction inférieur à celui du verre de la couche de verre mince (11, 17).
